Europäisches Patentamt

(19) European Patent Office

Office européen des brevets

(11) Publication number: **0 070 682**
**B1**

(12) **EUROPEAN PATENT SPECIFICATION**

(45) Date of publication of patent specification: **18.01.89**

(21) Application number: **82303695.9**

(22) Date of filing: **14.07.82**

(51) Int. Cl.⁴: **H 01 L 31/18,** H 01 L 21/205,
H 01 L 21/203

(54) Method of producing a semiconductor layer of amorphous silicon and a device including such a layer.

(30) Priority: **15.07.81 JP 109336/81**

(43) Date of publication of application:
**26.01.83 Bulletin 83/04**

(45) Publication of the grant of the patent:
**18.01.89 Bulletin 89/03**

(84) Designated Contracting States:
**DE FR GB NL**

(56) References cited:
**EP-A-0 058 543**
**US-A-4 237 150**
**THE CONFERENCE RECORD OF THE
FIFTEENTH IEEE PHOTOVOLTAIC
SPECIALISTS CONFERENCE - 1981, 12th-15th
May 1981, Kissimmee, Florida, pages 903-905,
IEEE, New York, US; D.P. TANNER et al.: "An
improved "P-type" hydrogenated amorphous
silicon"**

(73) Proprietor: **Hitachi, Ltd.
5-1, Marunouchi 1-chome
Chiyoda-ku Tokyo 100 (JP)**

(72) Inventor: **Shimomoto, Yasuharu
2196-92 Hirai Hinodemachi
Nishitamagun Tokyo (JP)**
Inventor: **Takasaki, Yukio
1-47-3-F404 Akatsuki-cho
Hachioji-shi Tokyo (JP)**
Inventor: **Sasano, Akira
2196-450 Hirai Hinodemachi
Nishitama-gun Tokyo (JP)**
Inventor: **Tsukada, Toshihisa
4-kou704-17-B405 Sekimachi
Nerima-ku Toikyo (JP)**

(74) Representative: **Paget, Hugh Charles Edward
et al
MEWBURN ELLIS & CO. 2/3 Cursitor Street
London EC4A 1BQ (GB)**

Courier Press, Leamington Spa, England.

(56) References cited:

THE CONFERENCE RECORD OF THE
FIFTEENTH IEEE PHOTOVOLTAIC
SPECIALISTS CONFERENCE - 1981, 12th-15th
May 1981, Kissimmee, Florida, pages 704-712,
IEEE, New York, US; A.E. DELAHOY et al.:
"Umpurity effects in a-Si:H solar cells"

IBM TECHNICAL DISCLOSURE BULLETIN, vol.
19, no. 12, May 1977, page 4802, New York, US;
M.H. BRODSKY et al.: "Doping of sputtered
amorphous semiconductors"

PATENTS ABSTRACTS OF JAPAN, vol. 5, no.
109 (E-65)781r, 15th July 1981; & JP - A - 56 49
578 (SUWA SEIKOSHA K.K.) 06-05-1981

PATENTS ABSTRACTS OF JAPAN, vol. 6, no.
247 (E-146)1125r, 7th December 1982; & JP - A -
57 147 279 (STANLEY DENKI K.K.) 11-09-1982

## Description

The invention relates to a method of producing a layer of hydrogenated amorphous silicon, and a semiconductor device including one or more such layers. Such a silicon layer is very useful, for example, as a photoelectric conversion layer.

Devices employing amorphous silicon for photoelectric conversion layers include solar cells and electrophotographic plates and also solid-state imaging devices, image pickup tubes, line sensors, MOS type TFTs (Thin Film Transistors) etc. whose photosensitive portions of which are made of the photoelectric conversion layers.

In such imaging devices, carriers are caused to migrate by applying an electric field to the photo-conversion layer. Also, where a photoelectric conversion layer is used in a transistor, carriers are caused to migrate. In the operation of such devices, the electric field dependence of the transition of the carriers excited in the photoelectric conversion layer is an important feature, and determines the quality of the device. Another important requirement in the use of photoelectric conversion layers in imaging devices is that the dark resistivity of the photoelectric conversion layer is at least $\sim 10^{10} \Omega.cm$. With a low dark resistivity, a time constant for charge storage shortens, so that the sensitivity of the device is degraded. Furthermore, the carriers perform a lateral flow, which is a cause of blur of a picture.

Methods used to produce hydrogenated amorphous silicon use glow discharge and reactive sputtering. These methods are described in, for example, US—A—4,064,521, US—A—4,117,506 and US—A—4,255,686.

In "The Conference Record of the 15th IEEE Photovoltaic Specialists Conference-1981", pages 903—905, there is described a glow discharge method for the production of amorphous silicon in which an atmosphere of nitrogen and silane is used.

An object of the present invention is to provide an amorphous silicon layer, particularly a photoconductive layer which achieves satisfactory photoelectric conversion with a low photocurrent voltage during irradiation by light, without reduction of the dark resistivity of the photoelectric conversion layer, with the aim of enhancement of the picture quality of imaging devices.

The method of the present invention is set out in claim 1. The invention is not limited to the production of photoconductive layers.

In the sputtering method, reactive sputtering may be performed using Si as a sputtering target in a gaseous mixture atmosphere whose basic component is an inert gas such as Ar and in which hydrogen and nitrogen are mixed.

The equipment and procedures used in the sputtering method may be those of conventional reactive sputtering techniques. The total pressure of the mixed gaseous atmosphere during sputtering is preferably in the range $6.5 \times 10^{-2}$ to 6.5 Pa ($5 \times 10^{-4}$ to $5 \times 10^{-2}$ Torr). The partial pressure of hydrogen is preferably in the range $1.3 \times 10^{-2}$ to 0.65 Pa ($1 \times 10^{-4}$ to $5 \times 10^{-3}$ Torr), and that of nitrogen in the range $1.3 \times 10^{-4}$ to $1.3 \times 10^{-2}$ Pa ($1 \times 10^{-6}$ to $10^{-4}$ Torr). The partial pressure of nitrogen should preferably be in the range from 1/300 to 1/30 that of hydrogen.

After the amorphous silicon film has been formed, it is preferably heated at a temperature in the range 200°C to 300°C for about 10 to 60 minutes.

In an alternative method for introducing hydrogen and particularly nitrogen into the plasma atmosphere, a silicon electrode which is to serve as a sputtering cathode is previously doped with nitrogen or with any reaction product of hydrogen and nitrogen, for example, ammonia. Nitrogen is then emitted from the cathode into the atmosphere during sputtering. The nitrogen content of the cathode electrode may be for example 10 to 1,000 ppm or so in terms of weight ratio.

In the reactive sputtering process, the input power is preferably set at approximately 0.2 to 3 W/cm², and the frequency can be at the usual value of 13.56 MHz. The temperature of the substrate during the formation of the film is preferably 150°C to 300°C. When the substrate temperature is too low, satisfactory photoconductive characteristics may not be obtained, whereas when it is too high, separation of the hydrogen content occurs unfavourably.

Embodiments of the invention will now be described by way of example with reference to the accompanying drawings, in which:-

Figure 1 is a schematic view of apparatus for the sputtering method;

Figures 2 and 12 are diagrams of arrangements for measurements of the characteristics of semiconductor films;

Figure 3 is a graph showing relationships between applied electric field and photocurrent;

Figure 4 is a graph showing relationships between nitrogen—hydrogen pressure ratio of a sputtering atmosphere and photocurrent;

Figure 5 is a diagram showing the principle of a solid-state imaging device;

Figures 6 and 7 are sectional views of the picture element portion of a solid-state imaging device;

Figure 8 is a graph showing spectral responses of solid-state imaging devices; and

Figures 9 to 11 are energy band model diagrams of photoelectric conversion portions.

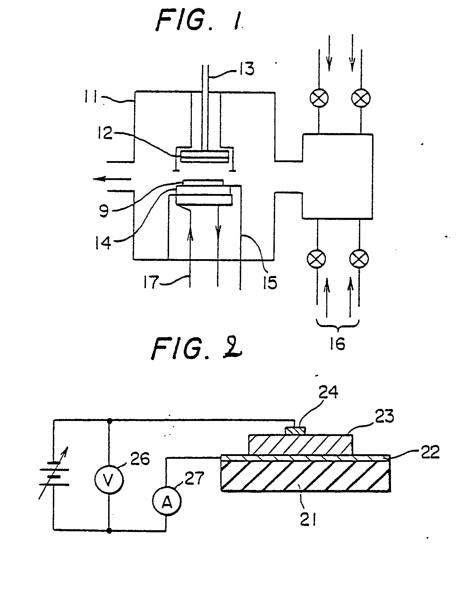

Figure 1 shows typical apparatus for producing hydrogenated amorphous silicon films.

In Figure 1 which illlustrates sputtering apparatus, there is shown a sample 9 in a vessel 11 which can be evacuated into vacuum, and a target 12 for sputtering, which is a sintered silicon compact or the like. There are also an electrode 13 for applying an r.f. voltage, a sample holder 14, a thermocouple 15 for measuring temperature, inlets 16 for a rare gas such as argon and a gas such as hydrogen, and a passage 17 for cooling water.

Embodiment 1:

This embodiment will be explained with reference to Figure 2. On an insulating substrate 21, a metal layer 22 of Cr or the like is formed to a thickness of 150 mm. Subsequently, a sintered compact of silicon is installed as a target in radio frequency sputtering equipment, and an amorphous silicon film 23 is formed on the resultant substrate 21 by reactive sputtering in a mixed atmosphere which contains argon at a pressure of 0.65 Pa ($5\times10^{-3}$ Torr), hydrogen at 0.4 Pa ($3\times10^{-3}$ Torr) and nitrogen at $1.3\times10^{-4}$ to $1.3\times10^{-3}$ Pa ($10^{-6}$ to $10^{-5}$ Torr). In various examples, the film 23 was 0.5 to 5 mm thick. A transparent electrode 24 made of $In_2O_3$ is formed on the film 23. With a potential applied across the electrode 22 and the transparent electrode 24, current and voltage in the amorphous silicon film 23 are respectively measured by an ammeter 27 and voltmeter 26. Light enter from the transparent electrode side.

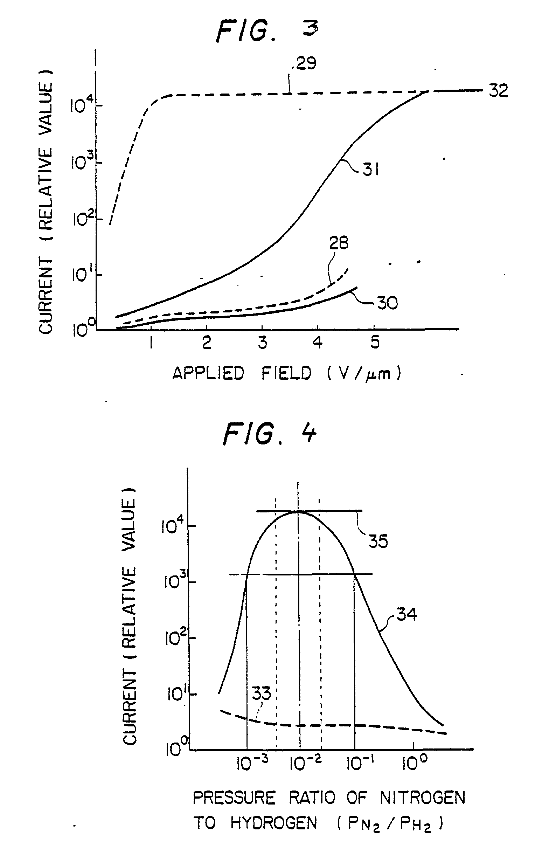

Figure 3 illustrates voltage-current characteristics for both dark current and photocurrent. The horizontal axis represents the electric field, while the vertical axis represents the current. The incident light has a wavelength of 450 nm and an intensity of about 10 $\mu W/cm^2$. Broken lines indicate the characteristics of the tested sample of this embodiment, while the solid lines indicate the characteristics of a sample obtained when nitrogen is not present in the sputtering atmosphere. The lines 28 and 30 are for the dark currents of the respective samples and show scarcely any difference.

On the other hand, for the photocurrents 29 and 31, the characteristic is sharply improved by the method of the present invention. With the photoelectric conversion layer produced according to the invention, the photoelectric device attains a high photoelectric conversion efficiency at a low electric field. The device has a high signal-to-noise ratio, and is operable at low electric field. The voltage required to be applied to the photoelectric conversion layer is accordingly low, so that a device having a low rate of shorting across its electrodes (i.e. a device having a low damage rate) can be readily obtained.

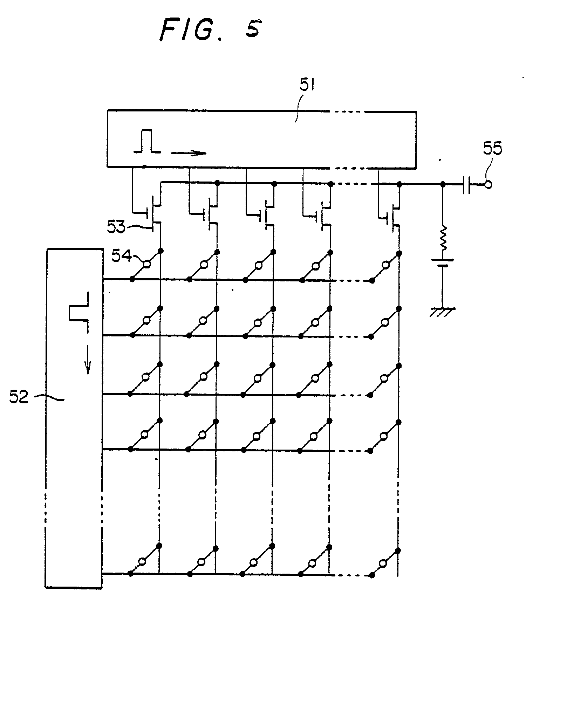

Figure 4 illustrates the effect of addition of different amounts of nitrogen gas in the atmosphere during the deposition of the amorphous silicon film. Curve 33 indicates the variation of the dark current, and a curve 34 the variation of the photocurrent. A straight line 35 indicates saturation values under the conditions of measurement (voltage is applied to the photoconductive films so as to establish an electric field of 1 V/$\mu$m). The horizontal axis represents the pressure ratio of $N_2$ to $H_2$ during the deposition of the film. The graph shows that the range of effective nitrogen gas concentration is 0.1 to 10%, in terms of the pressure ratio.

Embodiment 2:

Here a photoconductor film according to the invention was applied to a photoelectric conversion portion in a solid-state imaging device.

Figure 5 illustrates a typical solid-state imaging device, in which respective picture elements 54 are arranged in a checkerboard pattern, and are read out one-by-one by means of an XY-addressing system. Each picture element is selected by a horizontal scanning signal generator 51 and a vertical scanning signal generator 52. Switch portions 53 are connected to the corresponding picture elements, and there is an output terminal 55.

The photoelectric conversion portion of each picture element, which has a photoconductor film of the invention will now be described.

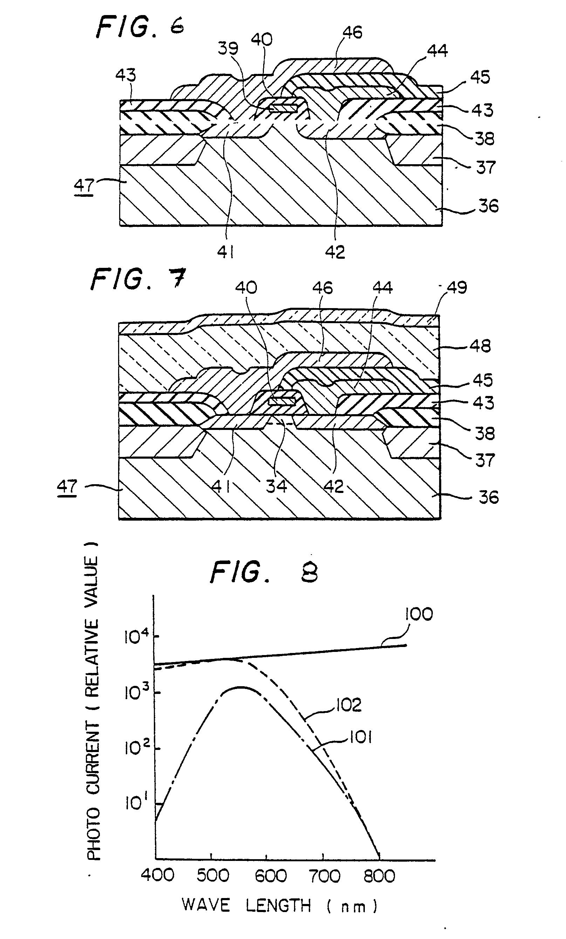

Figure 6 is a sectional view of the partly finished picture element portion. Figure 7 is a sectional view of the finished picture element portion.

Referring to Figure 6, a thin $SiO_2$ film of approximately 80 nm (800Å) is formed on a p-type silicon substrate 36, and an $Si_3N_4$ film of approximately 140 nm (1400 Å) is formed at a predetermined position on the $SiO_2$ film. The $Si_3N_4$ film is formed by a conventional CVD process. A p-type diffused region 37 is formed by ion implantation which is performed from above the resultant silicon substrate. This p-type diffused region is arranged to isolate the individual picture element portions. Subsequently, an $SiO_2$ layer 38 is formed by the local oxidation process which is usually called LOCOS. The $SiO_2$ film and the $Si_3N_4$ film thus far used as masks are removed, and a gate insulating film 39 for a MOS transistor is formed from another $SiO_2$ film.

Next, a gate portion 40 made of polycrystalline silicon and diffused regions 41 and 42 are formed. $SiO_2$ films 43 are formed on these regions. Electrode lead-out openings for the source 41 and the drain 42 are provided in the films 43 by etching. To form a drain electrode 44, Al is evaporated to a thickness of 800 nm. Then, an $SiO_2$ film 45 is formed to a thickness of 750 nm whereupon Al is evaporated to 1 $\mu$m thickness as a source electrode 46. In this example, the electrode 46 was extensively formed so as to cover the regions 41 and 42 and the gate portion 40. This is because when light enters the signal processing region inside the element isolating diffusion layer 37, it may undesirably be a cause of blooming.

Figure 6 shows the semiconductor body manufactured by the foregoing steps.

Subsequentaly, this semiconductor body 47 prepared by the foregoing steps is set up in a magnetron type sputtering equipment. In the example, the atmosphere was a gaseous mixture which consisted of Ar and hydrogen as well as nitrogen and whose pressure was 27 Pa (0.2 Torr). The hydrogen content was 6 mol %. The nitrogen content was about 0.1 volume %. The sputtering target was made of silicon. By performing reactive sputtering at a frequency of 13.56 MHz and a power of 300 W, a hydrogenated amorphous silicon film 48 was deposited on the semiconductor body 47 to a thickness of 500 nm. The hydrogen content of this amorphous film was 20 atomic %, and the resistivity was $5\times10^{13}\Omega \cdot cm$.

A first electrode 49 for a bias voltage needs to be disposed on the morphous silicon film 48. Now, since light needs to enter from above, this electrode is made transparent. Since the heat resistance of amorphous silicon is 300°C, a nesa electrode made of $In_2O_3$ was employed in this example. Cr-Au was evaporated using a mask onto that part of the nesa electrode which was not the light-receiving portion, and a wire was bonded to this to form the biasing electrode. A second electrode was formed as an Au film on the rear surface of the semiconductor substrate 36. In this way, the solid-state imaging device is finished.

In the conventional solid-state imaging device, the photoelectric conversion portion sensitive to light is a small area equal to 20 to 40% of each picture element, whereas in the present solid-state imaging device, substantially 100% of the picture element can serve as the photoelectric conversion portion. In addition, the photoelectric conversion film is improved and its spectral characteristics can be chosen, so that a solid-state imaging device having an enhanced sensitivity and an excellent spectral response can be provided.

Figure 8 illustrates the spectral response characteristics of the solid-state imaging device described above. The straight line 100 corresponds to a photelectric conversion efficiency of 100%. The horizontal axis represents the wavelength of visible radiation, while the vertical axis represents the photocurrent as a relative value. The curves show results obtained by applying an electric field of 2 V/µm to the photoelectric conversion layers. Curve 101 is for the case where the amorphous silicon film was made without nitrogen in the plasma atmosphere (prior art method), and curve 102 is for the case where the method of the present embodiment was used. In the latter case, on the shorter wavelength side, the photoelectric conversion efficiency reaches a value nearly equal to 100%. The reason why the photocurrent is reduced on the longer wavelength side is that the spectral response of the amorphous silicon film itself is low.

From the results of Figure 8, it can be seen that the effect obtainable with the present invention is remarkable.

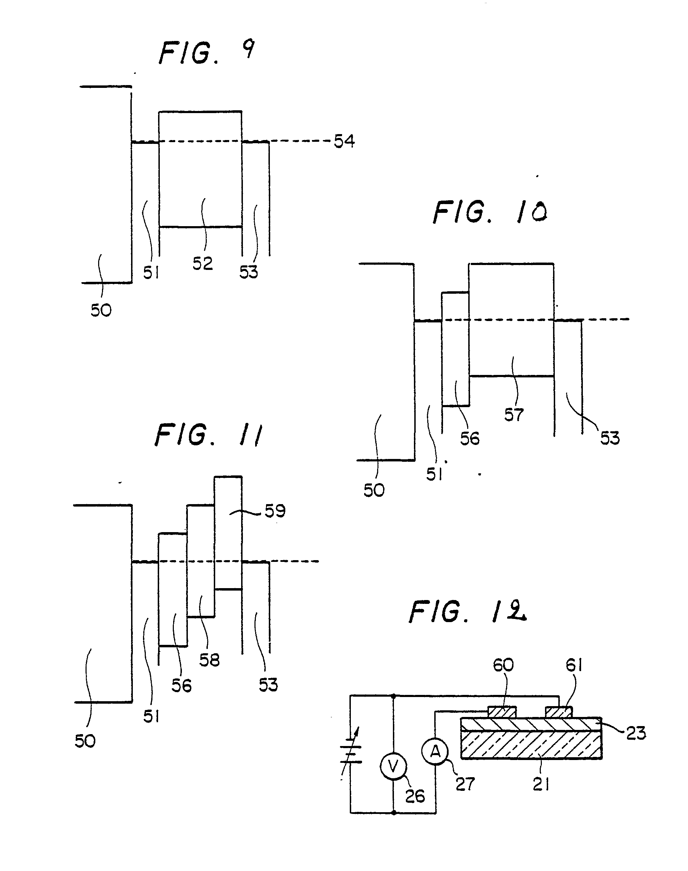

Figure 9 is a diagram of the energy state of a photoelectric conversion portion for electrons in an imaging device which employs a photoconductor formed by a method embodying the present invention. Shown are the surface 50 of a glass substrate or a scanning IC substrate for signal processing, electrodes 51, 53 across which a voltage is applied, a photoconductor layer 52 and the Fermi level 54. The electrode to which a negative potential is to be applied is transparent and the photoelectric conversion film is operated with light entering from this electrode.

In this case, the rate of injection of holes from the side opposite to the light entry side is lower in the film embodying the present invention than in prior art devices, so that the dark current level is lower and the dynamic characteristic of the pictures is enhanced. Furthermore, if the film is operated using a charge storage mode, the spectral photoelectric conversion efficiency is high for shorter wavelengths (400 to 500 nm) or longer wavelengths, so that good characteristics are exhibited. Such modes of operation are chiefly utilized in the photoelectric conversion films employed in solid-state imaging devices, electrophotographic plates, line sensors, etc. In these cases, the effective range of the thickness of the films is generally 0.3 to 0.5 µm.

Figure 10 is a band model diagram of an example in which two layers of photoconductor films 56 and 57 are used instead of the photoconductor film 52 shown in Figure 9. The photoconductor film 56 is an amorphous silicon film containing hydrogen and nitrogen, and embodies the present invention. The film 57 is a hydrogenated amorphous silicon film which does not contain nitrogen. The other parts are the same as in Figure 9, being a light transmitting substrate 50, a transparent electric conductor 51 and a metal electrode 53. Depending upon the direction of the incidence of light, the materials of the electrodes 51 and 53 are sometimes reversed.

Consider the mode of operation in which the electrode 51 of the device shown in Fig. 10 is held at a positive potential: the injection of holes at the interface between the electrode 51 and the amorphous silicon film 56 and the injection of electrons at the interface between the electrode 53 and the amorphous silicon 57 are blocked, so that the reduction of dark current is more remarkable. Further, inclinations for charges arising at the interface between the photoconductor layers 56 and 57 act in directions effective for the photoconductor layers. Accordingly, the device can operate with a potential which is still lower than the values indicated with reference to Figure 3. With this method of applying voltage, the device is effectively applicable in an image pickup tube.

In the case of Figure 11, the photoconductor film 57 is further divided into two layers, i.e. an amorphous silicon film 58 similar to the film 57 and p-type amorphous silicon film 59. Voltage is applied in this case with the positive sign at the electrode 51 and the negative sign at the electrode 53. In this case, besides the blocking of holes from the side of the electrode 51, the injection of electrons from the side of the electrode 53 is blocked more intensely than in the case of Figure 10, so that an imaging device of excellent dynamic characteristics can be realised.

Also, in this example, the multilayer films laminated in the thickness direction thereof are deposited on the side of the positive applied voltage. The films serve to block the dark current as described above and also can contribute to the generation of photocurrent in themselves, so that low voltage operation of the photocurrent is promoted and good pictures can be obtained.

Furthermore, in the case of Figure 11, even when no voltage is externally applied, the inclinations of potentials developing in the photoconductive films (56, 58, 59) can move carriers generated by the incidence of light on these parts. Accordingly, the device can be utilized as a solar cell.

The effective thickness of the photoconductive film 56 for use in the examples of Figures 10 and 11 lies, in general, within the range 0.01 to 5μm. When using the photoelectric conversion film for electrophotography, the upper limit of the film thickness naturally reaches several tens of microns, on account of the limitation voltage for the effective attraction of a toner. Even in this case, the photoconductive film formed by the method of the present invention is effective.

In the examples of Figures 9 to 11, the direction of the applied voltage and the direction of the incident light are not always fixed, but they can be reversed from those described, in dependence on the use of the devices.

The foregoing devices are shown utilized with the transit direction of carriers identical to the direction of the thickness of the film. However, the films made by the invention can also be utilized in devices in which the transit direction of carriers is in the direction of the plane of the film, for example, a TFT (Thin Film Transistor), and a MOS type FET. An advantage of this is that, since the film has a high resistivity, the "off" resistance need not be raised by forming a junction, so that the transistor can be fabricated simply.

The measurement of characteristics in this case is performed with a setup as shown in Figure 12, which shows an insulating substrate 21, a semiconductor film 23, and electrodes 60, 61 across which an electric field is applied in a direction parallel to the plane of the semiconductor film.

## Claims

1. A method of producing a semiconductor layer in which an amorphous silicon film (23, 48) is deposited on a substrate (21, 36 etc.) by sputtering using a plasma atmosphere which contains at least hydrogen and nitrogen characterised in that in the plasma atmosphere the ratio between the partial pressures of nitrogen and hydrogen is in the range 1/1000 to 1/10.

2. A method according to claim 1, wherein the amorphous silicon film (23, 48) is deposited on the substrate by a reactive sputtering process using silicon as a sputtering target, the plasma atmosphere containing at least a rare gas, hydrogen and nitrogen.

3. A method according to claim 1, wherein the amorphous silicon film is deposited on the substrate by a reactive sputtering process in which silicon containing nitrogen and/or reaction product of hydrogen and nitrogen is employed as a sputtering target, the plasma atmosphere containing at least a rare gas, hydrogen and nitrogen.

## Patentansprüche

1. Verfahren zur Herstellung einer Halbleiterschicht, wobei auf ein Substrat (21, 36 usw.) ein amorpher siliciumfilm (23, 48) durch Sputtern unter Verwendung einer mindestens Wasserstoff und Stickstoff enthaltenden Plasmaatmosphäre aufgetragen wird, dadurch gekennzeichnet, daß in der Plasmaatmosphäre das Verhältnis zwischen dem Partialdruck des Stickstoffs und dem des Wasserstoffs im Bereich von 1/1000 bis 1/10 liegt.

2. Verfahren nach Anspruch 1, wobei der amorphe Siliciumfilm (23, 48) durch einen Reaktiv-Sputtervorgang unter Verwendung von Silicium als Sputter-Target auf das Substrat aufgetragen wird, und wobei die Plasmaatmosphäre mindestens ein Édelgas, Wasserstoff und Stickstoff enthält.

3. Verfahren nach Anspruch 1, wobei der amorphe Siliciumfilm durch einen Reaktiv-Sputtervorgang, bei dem als Sputter-Target Silicium, das Stickstoff und/oder ein Reaktionsprodukt von Wasserstoff und Stickstoff enthält, auf das Substrat aufgetragen wird, und wobei die Plasmaatmosphäre mindestens ein Edelgas, Wasserstoff und Stickstoff enthält.

## Revendications

1. Procédé pour fabriquer une couche semiconductrice, selon lequel on dépose une pellicule de silicium amorphe (23, 48) sur un substrat (21, 36, etc.) au moyen d'un pulvérisation utilisant une atmosphère de plasma contenant au moins de l'hydrogène et de l'azote, caractérisé en ce que dans l'atmosphère de plasma, le rapport entre les pressions partielles de l'azote et de l'hydrogène se situe dans la gamme de 1/1000 à 1/10.

2. Procédé selon la revendication 1, selon lequel on dépose la pellicule de silicium amorphe (23, 48) sur le substrat au moyen d'un procédé pulvérisation réactive en utilisant du silicium comme cible de pulvérisation, l'atmosphère de plasma contenant au moins un gaz rare, de l'hydrogène et de l'azote.

3. Procédé selon la revendication 1, selon lequel on dépose la pellicule de silicium amorphe sur le substrat au moyen d'un procédé de pulvérisation réactive, pour lequel on utilise du silicium contenant de l'azote et/ou un produit de réaction de l'hydrogène et de l'azote en tant que cible de pulvérisation, l'atmosphère de plasma contenant au moins un gaz rare, de l'hydrogène et de l'azote.

# FIG. 1

# FIG. 2

## FIG. 3

## FIG. 4

# FIG. 5

*FIG. 6*

*FIG. 7*

*FIG. 8*

PHOTO CURRENT ( RELATIVE VALUE )

WAVE LENGTH ( nm )

## FIG. 9

54

51  52  53

50

## FIG. 10

57

56  53

51

50

## FIG. 11

59

58

56  53

51

50

## FIG. 12

60  61

23

27  21

26